Europäisches Patentamt

European Patent Office

Office européen des brevets

(11) Veröffentlichungsnummer: **0 071 915**
A2

## (12) EUROPÄISCHE PATENTANMELDUNG

(21) Anmeldenummer: 82106922.6

(22) Anmeldetag: 30.07.82

(51) Int. Cl.³: **H 01 L 29/72, H 01 L 29/06**

(30) Priorität: 10.08.81 DE 3131611

(43) Veröffentlichungstag der Anmeldung: 16.02.83
Patentblatt 83/7

(84) Benannte Vertragsstaaten: **CH DE FR GB IT LI**

(71) Anmelder: **SIEMENS AKTIENGESELLSCHAFT, Berlin
und München Wittelsbacherplatz 2,
D-8000 München 2 (DE)**

(72) Erfinder: **Strack, Helmut, Dr.phil., Speyerer Strasse 6,
D-8000 München 40 (DE)**

(54) **Epitaxialer Transistor.**

(57) Epitaxiale npn-Transistoren sind auf einem stark n-dotierten Substrat (1) aufgebaut, in dem p-dotierende Verunreinigungen, vor allem Bor, enthalten sein können. Die
Emitter- und Basiszonen (3, 4) werden bei hohen Temperaturen eindiffundiert, die gleichzeitig die Verunreinigungen
aus dem Substrat (1) austreiben. Damit wird entweder eine
p-dotierte Zwischenschicht zwischen Transistor und Substrat gebildet oder eine hochohmige Zwischenschicht durch
Gegendotierung erzeugt. Es ergibt sich entweder ein unerwünschter Thyristoreffekt, der zur Zerstörung der Bauelemente führen kann, oder eine Erhöhung des Bahnwiderstandes. Zur Vermeidung dieser Effekte wird zwischen das
Substrat und den Transistor eine n-dotierte Zwischenschicht (9) gelegt, deren Dotierung um den Faktor 2 bis 100
über dem der Epitaxieschicht liegt.

0071915

## 5. Epitaxialer Transistor

Die Erfindung bezieht sich auf einen Transistor mit einem stark n-dotierten Substrat, mit einer darauf epitaktisch abgeschiedenen schwächer n-dotierten ersten Zone, einer über der ersten Zone liegenden p-dotierten zweiten Zone und mit einer über der zweiten Zone liegenden n-dotierten dritten Zone.

Ein solcher Transistor ist in Form eines Leistungs-MOS-Transistors z. B. in der Zeitschrift "Electronic Design", July 5, 1980, Seite 66 beschrieben worden. Für bipolare Transistoren treffen diese Merkmale auch zu. Die für das Substrat verwendeten Scheiben werden aus der Schmelze gezogen und enthalten oft Verunreinigungen von p-dotierenden Elementen, insbesondere von Bor. Bei der Herstellung des Transistors werden in die schwach n-dotierte Epitaxieschicht bei Temperaturen zwischen 1000 und 1200 $^\circ$C Dotierstoffe eindiffundiert, die die Sourcezone und die Kanalzone des MOS-FET bzw. die Basiszone und die Emitterzone des bipolaren Transistors bilden. Bei diesen Temperaturen können die p-dotierenden Stoffe aus dem Substrat in die Epitaxieschicht eindiffundieren. Damit bildet sich entweder zwischen der schwach n-dotierten Epitaxieschicht des Transistors und dem Substrat durch Umdotierung eine p-dotierte Zwischenzone oder durch Gegendotierung eine hochohmige Zwischenzone. Diese Zwischenzone bewirkt einen Thyristoreffekt, der zur Zerstörung der Transistoren führen kann, bzw. bei MOS-Transistoren eine Erhöhung des Bahnwiderstandes.

Hab 1 Dx / 07.08.1981

0071915

Der Erfindung liegt die Aufgabe zugrunde, einen Transistor der eingangs erwähnten Art so weiterzubilden, daß die Ausbildung einer solchen Zwischenzone vermieden wird.

Die Erfindung ist dadurch gekennzeichnet, daß zwischen dem Substrat und der n-dotierten ersten Zone eine n-dotierte Zwischenschicht liegt, deren Dotierung 2- bis 100mal höher ist als die der ersten Zone.

Weiterbildungen der Erfindung sind Gegenstand der Unteransprüche.

Die Erfindung wird an Hand eines Ausführungsbeispiels in Verbindung mit den Fig. 1 bis 3 näher erläutert. Dabei sind gleiche Teile mit gleichen Bezugszeichen versehen. Es zeigen:

Fig. 1 den Schnitt durch einen Halbleiterkörper eines bipolaren Transistors mit der unerwünschten p-dotierten Zwischenzone,

Fig. 2 den Schnitt durch einen Halbleiterkörper eines MOS-FET mit der unerwünschten p-dotierten Zwischenzone und

Fig. 3 den Schnitt durch einen Halbleiterkörper gemäß der Erfindung, der für bipolare Transistoren und für MOS-FET Anwendung finden kann.

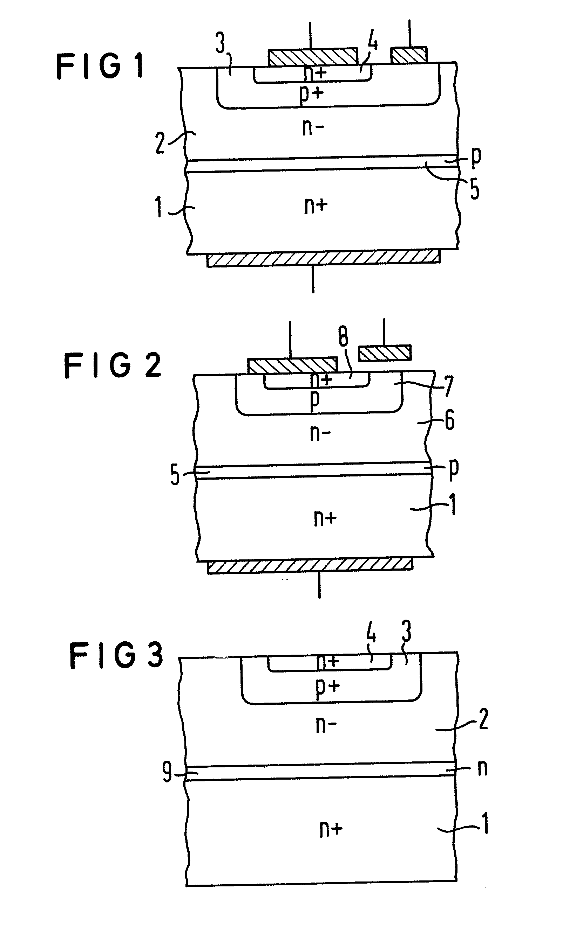

Der Halbleiterkörper nach Fig. 1 weist ein stark n-dotiertes Substrat 1 auf, auf dem der eigentliche Transistor aufgebaut ist. Über dem Substrat 1 befindet sich eine schwach n-dotierte Epitaxieschicht 2, die den Kollektor eines bipolaren Transistors bildet. In die Epitaxieschicht 2 ist eine zweite Zone 3 planar eingelagert. Diese Zone ist stark p-dotiert und bildet die Ba-

0071915

siszone. In die Basiszone 3 ist eine dritte Zone 4 planar eingelagert, die stark n-dotiert ist. Sie bildet den Emitter des Transistors. Die Zonen 3 und 4 können auch Mesa-Struktur haben. Zwischen dem Transistor mit den Zonen 2, 3 und 4 und dem Substrat liegt die p-leitende unerwünschte Zwischenzone 5. Der MOS-FET nach Fig. 2 ist ebenfalls auf einem stark n-dotierten Substrat 1 aufgebaut. Er weist eine epitaktisch abgeschiedene Sourcezone 6 auf, in die eine Kanalzone 7 planar eingelagert ist. Die Kanalzone ist p-dotiert. In die Kanalzone ist eine Sourcezone 8 planar eingelagert, die stark n-dotiert ist. Zwischen dem MOS-FET und dem Substrat, d. h. zwischen der Drainzone 6 und dem Substrat befindet sich wieder die unerwünschte p-dotierte Zwischenzone 5.

Die Zonen 4, 3, 2 und 5 bzw. 8, 7, 6 und 5 der Transistoren nach den Fig. 1 und 2 bilden einen unerwünschten npnp-Thyristor. Das hochdotierte Substrat 1 wirkt in beiden Fällen lediglich als Kontakt des Thyristors. Dieser Thyristoreffekt wird durch eine zwischen der Epitaxiezone 2 und dem Substrat 1 angeordnete Zwischenzone 9 vermieden. Diese ist um den Faktor 2 bis 100 höher dotiert als die Epitaxieschicht. Bei den erfahrungsgemäß vorkommenden Verunreinigungen des Substrats reicht dies aus, um aus dem Substrat ausdiffundierende p-dotierende Stoffe zu überdotieren bzw. die widerstandserhöhende Gegendotierung auszugleichen. Die Zwischenschicht 9 wird vorzugsweise epitaktisch abgeschieden, da hierbei eine Verunreinigung mit p-dotierenden Stoffen weitgehend ausgeschlossen ist. Die Dicke der Zwischenzone kann zwischen 1/100 und 1/2 der Gesamtdicke der Epitaxieschicht, d. h. der Dicke der Schicht 2 plus Dicke der Schicht 9, betragen. Allgemein gilt, daß bei hoher Dotierung der Zwischenschicht 9 eine geringe Dicke ausreicht, während bei niedriger Dotierung die Dicke der Zwischenschicht relativ groß gewählt werden muß.

0071915

Gebräuchliche Werte für die Dotierung der Epitaxieschicht 2 liegen zwischen $10^{13}$ und einigen $10^{16}$ Atome
$cm^{-3}$. Die Höhe der Dotierung richtet sich nach der Höhe
der Sperrspannung. Je höher die Sperrspannung ist, desto
niedriger muß die Epitaxieschicht dotiert sein und desto
größer muß ihre Dicke sein. Für eine Sperrspannung von
500 V empfiehlt sich beispielsweise eine Dotierung von
$3 \cdot 10^{14}$ und eine Dicke von 50 µm. Die Zwischenschicht
9 kann dann z. B. mit $3 \cdot 10^{16}$ Atomen $cm^{-3}$ dotiert und
3 µm dick sein. Bei einem 200 V-Transistor kann eine
Epitaxiedotierung von $6 \cdot 10^{14}$ und eine Dicke von 20 µm
sowie eine Dotierung der Zwischenschicht von $3 \cdot 10^{15}$
und eine Dicke von 6 µm angewandt werden.

Durch Anwendung der Zwischenschicht 9 wird der Thyristoreffekt vollständig vermieden. Damit ist es möglich,
die Sperrspannung bei gegebenen Transistorabmessungen zu
erhöhen, ohne daß eine Zerstörung der Bauelemente zu befürchten ist.

3 Figuren
3 Patentansprüche

0071915

<u>Patentansprüche</u>

1. Transistor mit einem stark n-dotierten Substrat (1), mit einer darauf epitaktisch abgeschiedenen schwächer n-dotierten ersten Zone (2; 6), einer über der ersten Zone liegenden p-dotierten zweiten Zone (3; 7) und mit einer über der zweiten Zone liegenden n-dotierten dritten Zone (4; 8), d a d u r c h   g e k e n n - z e i c h n e t ,   daß zwischen dem Substrat (1) und der n-dotierten ersten Zone (2; 6) eine n-dotierte Zwischenschicht (5) liegt, deren Dotierung 2- bis 100mal höher ist als die der ersten Zone (2; 6).

2. Transistor nach Anspruch 1,   d a d u r c h   g e - k e n n z e i c h n e t ,   daß die Zwischenschicht (5) epitaktisch abgeschieden ist.

3. Transistor nach Anspruch 1 oder 2,   d a d u r c h   g e k e n n z e i c h n e t ,   daß die Zwischenschicht (5) eine Dicke hat, die 1/2 bis 1/100 der Dicke der gesamten Epitaxieschicht beträgt.

1/1

0071915

FIG 1

FIG 2

FIG 3